# EUROPÄISCHE PATENTSCHRIFT

(11) **EP 2 988 576 B1**
(45) Veröffentlichungstag und Bekanntmachung des Hinweises auf die Patenterteilung: **13.04.2022**
(21) Anmeldenummer: 15178748.8
(22) Anmeldetag: 29.07.2015
(51) Int. Cl.: H05K 1/02, H05K 1/03

(54) **ANORDNUNG AUFWEISEND EINE LEITERPLATTE FÜR KRAFTFAHRZEUGBELEUCHTUNGSEINRICHTUNGEN**
ASSEMBLY WITH PRINTED CIRCUIT BOARD FOR MOTOR VEHICLE ILLUMINATION SYSTEMS
ASSEMBLAGE AVEC CARTE DE CIRCUIT POUR DISPOSITIFS D'ECLAIRAGE DE VEHICULE AUTOMOBILE

(30) Priorität: 20.08.2014 DE 202014006674 U
(43) Veröffentlichungstag der Anmeldung: 24.02.2016
(73) Patentinhaber: Automotive Lighting Reutlingen GmbH, 72762 Reutlingen (DE)
(72) Erfinder: Schöning, Michael, 37154 Northeim (DE); Temme, Jürgen, 72127 Kusterdingen-Immenhausen (DE); Kutschat, Jürgen, 72581 Dettingen (DE)
(74) Vertreter: DREISS Patentanwälte PartG mbB

(56) Entgegenhaltungen:
- EP-A2- 0 741 504
- DE-C2- 2 645 947
- JP-A- 2005 183 559
- US-A- 3 471 631
- US-A1- 2006 180 821

## Beschreibung

Die vorliegende Erfindung betrifft eine Anordnung nach Anspruch 1

EP 0 741 504 A2 offenbart eine Leiterplatte die einen Schichtstapel aus einer ersten Metallschicht, einer daran haftend anliegenden ersten dielektrischen Schicht, einer daran haftend anliegenden zweiten Metallschicht, einer daran haftend anliegenden zweiten dielektrischen Schicht und einer daran haftend anliegenden dritten Metallschicht aufweist, wobei die dritte Metallschicht dazu eingerichtet ist, auf ihr angeordnete Leistungsbauteile elektrisch zu kontaktieren und in den Leistungsbauteilen entstehende Wärme aufzunehmen und wobei die Leiterplatte metallische Durchkontaktierungen aufweist, welche die dritte Metallschicht thermisch mit der zweiten Metallschicht verbinden und Durchkontaktierungen aufweist, welche die zweite Metallschicht thermisch mit der ersten Metallschicht verbinden, wobei die erste dielektrische Schicht ein Bestandteil einer kupferkaschierten Schicht ist, die zweite dielektrische Schicht eine 85 Mikrometer dicke Schicht ist und die Durchkontaktierungen mit einer Metallisierung versehene Bohrungen sind.

Eine Leiterplatte mit einer ähnlichen Schichtfolge ist aus der US 2009/0154513 A1 bekannt. Allerdings gibt diese Schrift keine Hinweise auf eine Verwendung der Leiterplatte

in Kraftfahrzeugbeleuchtungseinrichtungen. Die dielektrische Schicht ist dort in einem Ausführungsbeispiel eine Flame-Retardant-4 (FR4) Schicht, zu deren Zusammensetzung in der genannten Schrift aber nichts offenbart wird.

In Kraftfahrzeugbeleuchtungseinrichtungen eingesetzte Leuchtdioden erzeugen große Lichtströme und damit auch große Joule'sche Verlustleistungen, die in Form von Wärme in den Chips der Leuchtdioden frei werden und die dann über die Leiterplatte abgeleitet werden müssen, um eine Selbstzerstörung der Chips durch Überhitzung zu verhindern. Der Vorgang der Wärmeableitung aus den Leuchtdioden wird auch als Entwärmung bezeichnet.

Kraftfahrzeugbeleuchtungseinrichtungen sind im Alltagsbetrieb vielfältigen Belastungen durch Vibrationen und wechselnde Temperaturen ausgesetzt, so dass in ihnen angeordnete Leiterplatten besonders robust sein müssen.

Vor diesem Hintergrund besteht die Aufgabe der vorliegenden Erfindung in der Angabe einer Leiterplatte der eingangs genannten Art, die robust ist und die eine elektrische Verlustwärme von Leuchtdioden, welche mit den für Kraftfahrzeugbeleuchtungseinrichtungen erforderlichen elektrischen Leistungen und damit verbundenen Verlustwärmen arbeiten, effektiv ableitet.

Diese Aufgabe wird mit den Merkmalen des Anspruchs 1 gelöst. Die vorliegende Erfindung unterscheidet sich unter anderem damit von dem eingangs genannten Stand der Technik dadurch, dass
- die erste dielektrische Schicht dicker als die zweite dielektrische Schicht ist;
- die zweite Metallschicht genauso dick wie die erste Metallschicht ist, die dritte Metallschicht dünner als die erste Metallschicht und auch dünner als die zweite Metallschicht ist; und
- die erste Metallschicht eine Unterseite des Schichtstapels bildet und die Unterseite des Schichtstapels mit einem Kühlkörper verbunden wird.

Durch diese Merkmale wird eine Leiterplatte für Kraftfahrzeugbeleuchtungseinrichtungen bereitgestellt, die sich durch eine hohe mechanische Festigkeit und Robustheit auszeichnet und die eine effektive Wärmeableitung ermöglicht.

Weitere Vorteile ergeben sich aus der nachfolgenden Beschreibung, den Zeichnungen und den Unteransprüchen. Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen. Wenn im Folgenden von einer Kupferlage oder Kupferschicht die Rede ist, soll damit jeweils sowohl reines Kupfer als auch eine Kupferlegierung gemeint sein.

Eine bevorzugte Ausgestaltung zeichnet sich dadurch aus, dass eine Durchkontaktierung, welche in der dritten Metallschicht endet, so angeordnet ist, dass ihr in der dritten Metallschicht liegendes Ende in einem Fußabdruck eines dort zu montierenden Bauteils liegt.

Bevorzugt ist auch, dass die dritte Metallschicht dazu eingerichtet ist, auf ihr angeordnete Bauelemente, insbesondere Leuchtdioden, elektrisch und thermisch zu kontaktieren.

Ferner ist bevorzugt, dass die Dicke der ersten Metallschicht 84 bis 254 pm beträgt.

Eine weitere bevorzugte Ausgestaltung zeichnet sich dadurch aus, dass die erste Metallschicht aus Kupfer oder einer Kupfer aufweisenden Legierung besteht.

Bevorzugt ist auch, dass die erste dielektrische Schicht eine FR4-Schicht aus einem faserverstärkten aushärtenden Harz ist. Alternativ ist bevorzugt, dass die erste dielektrische Schicht eine CEM-3 Schicht ist (CEM = composite epoxy material). Eine CEM-3 Schicht weist an Stelle der verwebten Fasern der FR4-Schicht Glasfaser-Schnitzel auf.

Ferner ist bevorzugt, dass die auf der ersten dielektrischen Schicht aufliegende zweite Metallschicht 84 bis 254 pm dick ist.

Ferner ist bevorzugt, dass die zweite Metallschicht aus dem gleichen Metall wie die erste Metallschicht besteht. Bevorzugt ist auch, dass die zweite dielektrische Schicht eine FR4-Schicht aus einem faserverstärkten aushärtenden Harz oder eine CEM-3 Schicht ist.

Bevorzugt ist auch, dass die Metallisierung der Bohrungen aus dem Metall besteht, aus dem auch die zu verbindenden Metallschichten bestehen, also insbesondere bevorzugt aus Kupfer oder einer Kupfer aufweisenden Legierung.

Eine weitere bevorzugte Ausgestaltung zeichnet sich dadurch aus, dass die Schichtdicke der Metallisierung der Bohrungen kleiner als der Radius der Bohrung ist, so dass sich hülsenartige metallische Durchkontaktierungen ergeben. Bevorzugt ist auch, dass die erste dielektrische Schicht ein Bestandteil eines kupferkaschierten Halbfertigprodukts ist, wobei die erste dielektrische Schicht zwischen einer oberen Kupferschicht und einer unteren Kupferschicht eingebettet ist.

Die Dicke der ersten dielektrischen Schicht ist bevorzugt größer als die Dicke der zweiten dielektrischen Schicht. Ferner ist bevorzugt, dass die erste dielektrische Schicht eine Dicke von 700, 1000, 1200 oder 1550 pm Dicke aufweist. Ausführungsbeispiele der Erfindung sind in den Zeichnungen dargestellt und werden in der nachfolgenden Beschreibung näher erläutert.

Dabei zeigen, jeweils in schematischer Form:
- Figur 1: eine Schrägansicht einer mit einer Leuchtdiode bestückten Leiterplatte zusammen mit einem Kühlkörper; und
- Figur 2: einen Querschnitt durch ein Ausführungsbeispiel einer erfindungsgemäßen Leiterplatte.

Dabei bezeichnen gleiche Bezugszeichen in verschiedenen Figuren jeweils gleiche oder zumindest ihrer Funktion nach vergleichbare Elemente.

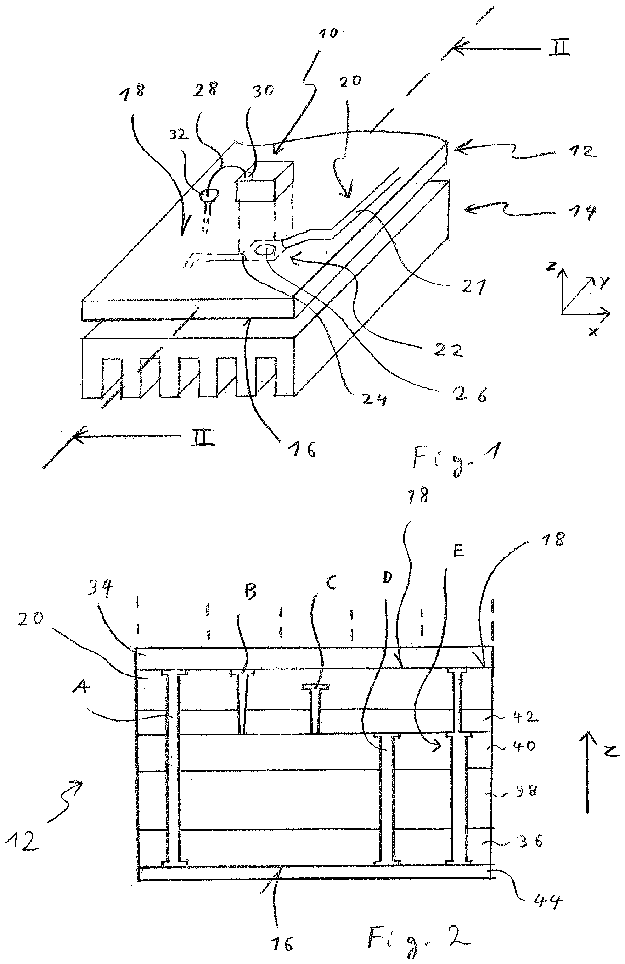

Im Einzelnen zeigt die Figur 1 eine Schrägansicht einer mit einem elektrischen oder elektronischen Bauelement 10 bestückten Leiterplatte 12 zusammen mit einem Kühlkörper 14. Das Bauelement 10 ist bevorzugt eine Leuchtdiode. Die Leiterplatte 12 und der Kühlkörper 14 sind in der Figur 1 durch einen Abstand getrennt voneinander dargestellt. Sie werden bei der Verwendung der Leiterplatte in einer Beleuchtungseinrichtung eines Kraftfahrzeugs jedoch zu einer Baugruppe zusammengefügt sein, in welcher der Kühlkörper 14 die Unterseite 16 der Leiterplatte 12 thermisch kontaktiert, um Wärme aus der Leiterplatte 12 aufzunehmen und an die Umgebung abzugeben.

Die Leiterplatte 12 weist zusätzlich zu der dem Kühlkörper 14 zugewandten Unterseite 16 eine dem Kühlkörper abgewandte und mit Bauelementen 10 bestückte Oberseite 18 auf. Im dargestellten Beispiel ist eine einzelne Leuchtdiode als Bauelement 10 dargestellt. Im Normalfall wird eine Leiterplatte 12, die für eine Verwendung in einer Beleuchtungseinrichtung eines Kraftfahrzeuges bestimmt ist, mit mehr als einer Leuchtdiode und ggf. auch weiteren Bauelementen 10 bestückt sein, was hier lediglich aus Gründen der Übersichtlichkeit nicht dargestellt ist. Die Begriffe Oberseite und Unterseite beziehen sich hier nur auf die Darstellung in den Figuren 1 und 2 und sollen nicht als einschränkende Orientierungsmerkmale verstanden werden. Es versteht sich, dass die Leiterplatte auch in anderen Orientierungen verwendet werden kann, zum Beispiel in einer Orientierung, in der die Seite 18 eine rechte Seite und die Seite 16 eine linke Seite sein kann.

Die Seite 18 der Leiterplatte ist mit einer metallischen Schicht 20 versehen, die in der Ebene der Seite 18 strukturiert ist, wobei die strukturierte Schicht 20 insbesondere Leiterbahnen 21 zur elektrischen Kontaktierung der Bauelemente 10, Anschlusspads 24 zur elektrischen und gegebenenfalls ergänzend auch thermischen Kontaktierung der Bauelemente 10 und gegebenenfalls nur zur thermischen Kontaktierung der Bauelemente 10 dienende weitere Anschlusspads 26 aufweist. Die Anschlusspads 24 und 26 befinden sich bevorzugt in einem Fußabdruck 22 des Bauteils 10 auf der Oberseite der Leiterplatte, wobei unter dem Fußabdruck hier die Fläche verstanden wird, die von dem Bauteil 10 nach dessen Montage auf der Leiterplatte 12 eingenommen wird.

Alternativ oder ergänzend kann die thermische und/oder elektrische Kontaktierung auch über Bonddrähte 28 erfolgen, mit denen außerhalb der Leiterplatten-Oberseiten-Ebene liegende Anschlüsse 30 der Bauteile 10 mit in der Oberseite und außerhalb des Fußabdrucks 22 liegenden Anschlusspads 32 verbunden sind, die ebenfalls Bestandteile der metallischen Schicht 20 sind. Die Oberseite 18 und die Unterseite 16 sind parallel zur x-y-Ebene eines mit der Leiterplatte 12 verankerten rechtshändigen, kartesischen Koordinatensystems angeordnet. Die Dicke der Leiterplatte 12 entspricht dem Abstand der Oberseite 18 von der Unterseite 16 der Leiterplatte 12 und liegt parallel zur z-Richtung des genannten Koordinatensystems.

Die Metallschicht 20 ist eine dritte Metallschicht und ist im einsatzfertigen Zustand dazu eingerichtet, auf ihr angeordnete Bauelemente 10, insbesondere Leuchtdioden, elektrisch und thermisch zu kontaktieren. Dazu dienen die Leiterbahnen 21 und Anschlusspads 24, 26, 32, die sich als Folge der Strukturierung der dritten Metallschicht 20 in voneinander getrennte lineare und flächige Strukturen ergeben. Die Strukturierung erfolgt z.B. durch Lithografie- und Ätz-Techniken. Die Anschlusspads 26, 32 werden bei der Fertigung z.B. mit einem festen, aber aufschmelzbaren Lötmittel versehen. Dann werden die Leuchtdioden mit ihren elektrischen Anschlüssen auf die Pads aufgesetzt, und das Lötmittel wird aufgeschmolzen, so dass sich eine elektrisch leitfähige Verbindung zwischen auf der Leiterplatte verlaufenden Leiterbahnen der Leiterplatte und /oder in die Tiefe der Leiterplatte hinabreichenden Durchkontaktierungen auf der einen Seite und dem jeweiligen Bauteil auf der anderen Seite ergibt.

Die im Betrieb im Bauteil 10, also insbesondere im Chip einer Leuchtdiode frei werdende Verlustwärme wird über die zur elektrischen und thermischen Kontaktierung dienenden Anschlusspads 24 und/oder über Bonddrähte 28 und/oder über die nur zur Entwärmung dienenden Anschlusspads 26 dieser Leuchtdiode in die Leiterplatte eingeleitet und durch im Folgenden noch zu erläuternde Strukturen zur Unterseite 16 der Leiterplatte geleitet. Die Unterseite 16 ist beim Einsatz der Leiterplatte in der Beleuchtungseinrichtung thermisch mit dem Kühlkörper 14 verbunden, der diese Wärme aufnimmt und an die Umgebung abführt.

Die Figur 2 zeigt im Einzelnen einen Schichtstapel aus einer ersten Metallschicht 36, einer daran haftend anliegenden ersten dielektrischen Schicht 38, einer daran haftend anliegenden zweiten Metallschicht 40, einer daran haftend anliegenden zweiten dielektrischen Schicht 42 und einer daran haftend anliegenden dritten Metallschicht 20. Die erste Metallschicht 36 bildet mit einer ihrer zwei ausgedehnten Schichtflächen die Seite/Unterseite 16 dieses Schichtstapels. Der Kühlkörper 14 wird mit der Unterseite 16 bevorzugt über eine Schicht 44 verbunden, die elektrisch isoliert, aber thermisch gut leitfähig ist und die z.B. aus Lötstopplack besteht. Die Dicke der ersten Metallschicht 36 beträgt bevorzugt 84 bis 254 µm. Sie besteht bevorzugt aus Kupfer oder einer Kupfer aufweisenden Legierung.

Die erste dielektrische Schicht 38 bildet einen Kern der Leiterplatte 12, welcher der Leiterplatte ihre mechanische Stabilität verleiht. Bei der ersten dielektrischen Schicht 38 handelt es sich bevorzugt um eine FR4-Schicht aus einem faserverstärkten aushärtenden Harz, insbesondere um ein mit einem solchen Harz gefülltes, verwebtes Glasfasergeflecht. Alternativ kann es sich auch um eine CEM-3 Schicht handeln. Die auf der ersten dielektrischen Schicht 38 aufliegende zweite Metallschicht 40 ist bevorzugt 84 bis 254 pm dick. Sie ist genauso dick wie die erste metallische Schicht 36. Sie besteht bevorzugt aus dem gleichen Metall wie die erste Metallschicht 36, insbesondere aus Kupfer oder einer Kupfer aufweisenden Legierung.

Auf der zweiten Metallschicht 40 liegt die zweite dielektrische Schicht 42 anhaftend auf. Bei der zweiten dielektrischen Schicht 42 handelt es sich bevorzugt um eine FR4-Schicht aus einem faserverstärkten aushärtenden Harz. Es handelt sich auch hier bevorzugt um ein mit Harz gefülltes, verwebtes Glasfasergeflecht. Alternativ handelt es sich um eine CEM-3 Schicht. Die zweite dielektrische Schicht 42 ist maximal 100 pm dick. Die dritte Metallschicht 20 ist zunächst bevorzugt eine Metallfolie von 20 bis 25 pm Dicke. Die zweite Metallschicht 20 ist dünner als die erste Metallschicht und auch dünner als die zweite Metallschicht. Die zweite Metallschicht besteht bevorzugt aus Kupfer oder einer Kupfer aufweisenden Legierung. Die dritte Metallschicht 20 wird bei der Fertigung der Leiterplatte 12 bevorzugt auf den übrigen Schichtstapel aufgepresst und später so strukturiert, dass sich die oben genannten Anschlusspads und Leiterbahnen ergeben.

Die Leiterplatte 12 weist metallische Durchkontaktierungen A, B, C auf, welche die dritte Metallschicht 20 thermisch mit der zweiten Metallschicht 40 verbinden. Die Leiterplatte weist ferner metallische Durchkontaktierungen A, D, E auf, welche die zweite Metallschicht 40 thermisch mit der ersten Metallschicht 36 verbinden. Die Durchkontaktierungen sind mit einer Metallisierung versehene Bohrungen. Die Metallisierung besteht bevorzugt aus dem Metall, aus dem auch die zu verbindenden Metallschichten bestehen, also insbesondere bevorzugt aus Kupfer oder einer Kupfer aufweisenden Legierung. Die Schichtdicke der Metallisierung der Bohrungen ist bevorzugt kleiner als der Radius der Bohrung, so dass sich hülsenartige metallische Durchkontaktierungen ergeben.

Die der Oberseite 18 zugewandte dritte Metallschicht 20 ist im Endzustand in Anschlusspads und Leiterbahnen strukturiert, wobei die Strukturierung durch Lithografieschritte und Ätzschritte erfolgen kann. Die Entwärmung der auf der Leiterplatte angeordneten Bauteile, insbesondere der Leuchtdioden, erfolgt über ihre dafür vorgesehenen Anschlusspads. Wärme, die im Betrieb einer Leuchtdiode in ihrem Halbleiterchip frei wird, fließt über das jeweilige Anschlusspad zunächst in die dritte Metallschicht 20 und wird von dort über die Durchkontaktierungen schnell abgeführt. Dabei dient die zweite Metallschicht 40 gewissermaßen als Puffer, der schnell Wärme aufnehmen und in seiner Fläche verteilen kann. Die Fähigkeit zur schnellen Wärmeaufnahme ergibt sich dabei daraus, dass dieser Puffer wegen der geringen Dicke der zweiten dielektrischen Schicht 42 sehr dicht an den Leuchtdioden/Bauteilen liegt. Dadurch wird einer Entstehung unerwünschter lokaler Temperaturspitzen effektiv entgegengewirkt.

Von der zweiten Metallschicht 40 wird die dort aufgenommene Wärme über die Durchkontaktierungen vom Typ A, D und E zur ersten Metallschicht 36 geleitet, wobei die erste dielektrische Schicht 38 thermisch lokal überbrückt wird. Die gerade durchgehende Durchkontaktierung vom Typ A ist zur Entwärmung von Anschlusspads geeignet, die kein elektrisches Potential besitzen. Dies gilt analog für die Durchkontaktierung vom Typ E, die ebenfalls die dritte Metallschicht 20 thermisch in einer Flucht mit der zweiten Metallschicht 40 und der ersten Metallschicht 36 verbindet. Herrscht dagegen auf dem zu erwärmenden Anschlusspad ein elektrisches Potential, wird die Durchkontaktierung vom Typ B und/oder D verwendet. Bei dieser Art von Durchkontaktierung muss die erste Metallschicht 36 und die zweite Metallschicht 40 ggf. in Leiterbahnen strukturiert werden, so wie es bei der dritten Metallschicht 20 der Fall ist, um elektrische Kurzschlüsse zwischen verschiedenen Pads der gleichen Leuchtdiode oder verschiedenen Pads von verschiedenen Leuchtdioden zu vermeiden.

Im Folgenden wird die Herstellung eines Ausführungsbeispiels einer erfindungsgemäßen Leiterplatte 12 erläutert.

Die erste dielektrische Schicht 38 ist bevorzugt ein Bestandteil eines kupferkaschierten Halbfertigprodukts, wobei die erste dielektrische Schicht 38 zwischen einer oberen Kupferschicht und einer unteren Kupferschicht eingebettet ist. Das dielektrische Kernmaterial weist bevorzugt eine Dicke von 700, 1000, 1200 oder 1550 pm Dicke auf. Die obere Kupferschicht und die untere Kupferschicht weist bevorzugt jeweils eine Dicke von 70 bis 210 pm auf. Das kupferkaschierte Halbfertigprodukt wird zunächst so stark erwärmt, dass das Harz aushärtet. Dann werden an den Stellen, an denen später die Durchkontaktierungen liegen sollen, Löcher gebohrt. Diese Löcher haben in einer bevorzugten Ausgestaltung einen Durchmesser von 0,5 mm. Die Löcher werden entweder mechanisch gebohrt oder mit einem Laser erzeugt. In einem anschließenden Metallisierungsschritt, der bevorzugt durch ein Metallisierungsbad erfolgt, werden die Innenflächen der Bohrungen mit Metall belegt. Bei dem Metall handelt es sich bevorzugt um das gleiche Metall wie beim Material der ersten Metallschicht und/oder der zweiten Metallschicht. Es handelt sich also insbesondere bevorzugt um Kupfer oder einer Kupfer aufweisenden Legierung . Die Dicke der Metallisierung beträgt in den Bohrungen bevorzugt 20 bis 25 pm.

Bei der Metallisierung der Bohrung scheidet sich auch Metall auf der ersten Metallschicht und der zweiten Metallschicht des Halbfertigprodukts ab, so dass sich die Dicke der jeweiligen Metallschichten vergrößert. Im Ergebnis beträgt die Dicke der ersten Metallschicht 36 und der zweiten Metallschicht 40 bevorzugt mehr als jeweils 84 pm. Auf diese Art und Weise werden Durchkontaktierungen vom Typ D und E, welche nur die erste Metallschicht thermisch mit der zweiten Metallschicht verbinden, erzeugt. Auf den so prozessierten Kern wird anschließend die zweite dielektrische Schicht 42 mit maximal 100 pm Dicke aufgebracht.

Die zweite dielektrische Schicht 42 ist ein sog. Prepreg, also ein harzgefülltes, verwebtes Glasfasergeflecht. Anschließend wird darauf eine Metallfolie, insbesondere eine Kupferfolie von bevorzugt 18 bis 35 pm Dicke als dritte Metallschicht 20 aufgebracht. Die dritte Metallschicht kann auch aus mehreren dünnen Folien aufgebaut sein, um Durchkontaktierungen vom Typ C zu verwirklichen.

Die thermische Anbindung der dritten Metallschicht 20 an die zweite Metallschicht 40 erfolgt durch Durchkontaktierungen vom Typ A, B, C oder E. Dazu werden bevorzugt Löcher gebohrt, und in einem Metallisierungsschritt werden diese Löcher mit einer Metallisierung versehen, wie es weiter oben bereits für die Verbindung der zweiten Metallschicht 40 und der dritten Metallschicht 20 beschrieben worden ist. Die Löcher werden entweder mechanisch gebohrt oder mit einem Laser erzeugt. Die Löcher sind, wie bei der Durchkontaktierung vom Typ A, bevorzugt so groß wie die Löcher, die für die Durchkontaktierungen verwendet werden, mit denen die zweite Metallschicht 40 thermisch mit der dritten Metallschicht 20 verbunden wird. Dies gilt z.B. für die Durchkontaktierung vom Typ A. Allerdings ist bevorzugt, dass für die thermische Verbindung der dritten Metallschicht 20 mit der zweiten Metallschicht 40 Löcher mit kleinerem Durchmesser verwendet werden. Auch hier gilt, dass die Schichtdicke der dritten Metallschicht 20 durch die Metallisierung zunimmt.

Bei einem Beispiel einer Leiterplatte wird auf eine von zwei vergleichsweise dicken Kupferlagen, die durch ein Dielektrikum getrennt sind, ein weiteres Dielektrikum mit einer weiteren Kupferlage aufgebracht. Diese weitere Kupferlage weist eine im Vergleich zu der Dicke der zwei vergleichsweise dicken Kupferlagen geringere Dicke auf. Die geringere Dicke beträgt bevorzugt ungefähr 1 Zehntel bis ein Viertel der Dicke der vergleichsweis dickeren Kupferlagen. Die vergleichsweise weniger dicke Kupferlage ist mit bevorzugt lasergebohrten oder mechanisch gebohrten Durchkontaktierungen thermisch mit den beiden vergleichsweise dicken Kupferlagen verbunden. Bevorzugt sind auch die beiden dicken Kupferlagen durch solche Durchkontaktierungen miteinander verbunden. Es sind stets drei elektrisch und thermisch leitende Lagen (Metallschichten) vorhanden.

Eine Durchkontaktierung, welche in der dritten Metallschicht endet, ist bevorzugt so angeordnet, dass ihr Ende in einem Fußabdruck eines dort zu montierenden Bauteils liegt. Vergleiche Figur 2. Dies spart Platz und ist manchmal, nämlich bei einer hohen Packungsdichte von Bauteilen und / oder Leiterbahnen auf der Leiterplatte, auch die einzige Möglichkeit, wärmeerzeugende Bauteile wie Leuchtdioden zu entwärmen.

Die erfindungsgemäße Leiterplatte ermöglicht einen schnellen Abfluss von Wärme aus dem Bauteil in die zweite Metallschicht 40, die als Puffer und Wärmesenke dient und ihrerseits die aufgenommene Wärme über die Durchkontaktierungen zur ersten Metallschicht und damit letztlich zum Kühlkörper weitergibt. Das relativ dicke Kernmaterial aus der ersten Metallschicht, der ersten dielektrischen Schicht und der zweiten Metallschicht gewährleistet eine vorteilhaft hohe Verwindungssteifigkeit. Die erfindungsgemäße Leiterplatte bietet die Vorteile einer Material- und einer Zeitersparnis bei der Produktion. Außerdem bietet die Erfindung den Vorteil einer effektiven und schnellen Entwärmung von sehr kleinen Bauelementen wie Leuchtdioden in Kraftfahrzeugbeleuchtungseinrichtungen.

## Patentansprüche

1. Anordnung aufweisend eine Leiterplatte (12) für Kraftfahrzeugbeleuchtungseinrichtungen die einen Schichtstapel aus einer ersten Metallschicht (36), einer daran haftend anliegenden ersten dielektrischen Schicht (38), einer daran haftend anliegenden zweiten Metallschicht (40), einer daran haftend anliegenden zweiten dielektrischen Schicht (42)und einer daran haftend anliegenden dritten Metallschicht (20) aufweist, wobei die dritte Metallschicht dazu eingerichtet ist, auf ihr angeordnete Leuchtdioden elektrisch zu kontaktieren und in den Leuchtdioden entstehende Wärme aufzunehmen und wobei die Leiterplatte (12) metallische Durchkontaktierungen (A, B, C, E) aufweist, welche die dritte Metallschicht (20) thermisch mit der zweiten Metallschicht (40) verbinden und Durchkontaktierungen (A, D, E) aufweist, welche die zweite Metallschicht (40) thermisch mit der ersten Metallschicht (36) verbinden, wobei die erste dielektrische Schicht (38) ein Bestandteil einer kupferkaschierten Schicht aus einem faserverstärkten Harz ist, die zweite dielektrische Schicht (42) eine maximal 100 Mikrometer dicke Schicht aus faserverstärktem Harz ist, die Durchkontaktierungen mit einer Metallisierung versehene Bohrungen sind, dass die erste dielektrische Schicht (38) dicker als die zweite dielektrische Schicht ist, dass die zweite Metallschicht (40) genauso dick wie die erste Metallschicht (36) ist, und dass die dritte Metallschicht (20) dünner als die erste Metallschicht und auch dünner als die zweite Metallschicht (40) ist, wobei die erste Metallschicht (36) eine Unterseite (16) des Schichtstapels bildet und die Unterseite (16) des Schichtstapels mit einem Kühlkörper verbunden ist.

2. Anordnung nach Anspruch 1, **dadurch gekennzeichnet, dass** eine Durchkontaktierung, welche in der dritten Metallschicht (20) endet, so angeordnet ist, dass ihr in der dritten Metallschicht (20) liegendes Ende in einem Fußabdruck (22) eines dort zu montierenden Bauteils liegt.

3. Anordnung nach einem der vorhergehenden Ansprüche, **dadurch gekennzeichnet, dass** die dritte Metallschicht (20) dazu eingerichtet ist, auf ihr angeordnete Bauelemente (10), insbesondere Leuchtdioden, elektrisch und thermisch zu kontaktieren.

4. Anordnung nach einem der vorhergehenden Ansprüche, **dadurch gekennzeichnet, dass** die Dicke der ersten Metallschicht (36) 84 bis 254 µm beträgt.

5. Anordnung nach einem der vorhergehenden Ansprüche, **dadurch gekennzeichnet, dass** die erste Metallschicht (36) aus Kupfer oder einer Kupfer aufweisenden Legierung besteht.

6. Anordnung nach einem der vorhergehenden Ansprüche, **dadurch gekennzeichnet, dass** die erste dielektrische Schicht (38) eine FR4-Schicht aus einem faserverstärkten aushärtenden Harz oder eine CE-3 Schicht ist.

7. Anordnung nach einem der vorhergehenden Ansprüche, **dadurch gekennzeichnet, dass** die auf der ersten dielektrischen Schicht (38) aufliegende zweite Metallschicht (40) 84 bis 254 µm dick ist.

8. Anordnung nach einem der vorhergehenden Ansprüche, **dadurch gekennzeichnet, dass** die zweite Metallschicht (40) aus dem gleichen Metall wie die erste Metallschicht (36) besteht.

9. Anordnung nach einem der vorhergehenden Ansprüche, **dadurch gekennzeichnet, dass** die zweite dielektrische Schicht (42) eine FR4-Schicht aus einem faserverstärkten aushärtenden Harz oder eine CEM-3 Schicht ist.

10. Anordnung nach einem der vorhergehenden Ansprüche, **dadurch gekennzeichnet, dass** die Metallisierung der Bohrungen aus dem Metall besteht, aus dem auch die zu verbindenden Metallschichten bestehen, also insbesondere bevorzugt aus Kupfer oder einer Kupfer aufweisenden Legierung.

11. Anordnung nach Anspruch 10, **dadurch gekennzeichnet, dass** die Schichtdicke der Metallisierung der Bohrungen kleiner als der Radius der Bohrung ist, so dass sich hülsenartige metallische Durchkontaktierungen ergeben.

## Claims

1. Assembly comprising a printed circuit board (12) for motor vehicle illumination systems comprising a stack of layers consisting of a first metal layer (36), a first dielectric layer (38) attached to it, a second metal layer (40) adhering thereto, and a second dielectric layer (42) adhering thereto, and a third metal layer (20) adhering thereto, whereby the third metal layer is designed to make electrical contact with the light-emitting diodes positioned on it and to absorb heat generated in the light-emitting diodes, and whereby the printed circuit board (12) comprises metallic through-contacts (A, B, C, E) that thermally connect the third metal layer (20) with the second metal layer (40) and comprising through-contacts (A, D, E) that thermally connect the second metal layer (40) with the first metal layer (36), whereby the first dielectric layer (38) is part of a copper-clad layer of a fiber-reinforced resin, the second dielectric layer (42) is a layer of fiber-reinforced resin with a maximum thickness of 100 micrometers, the through-contacts are metallized bores, the first dielectric layer (38) is thicker than the second dielectric layer, the second metal layer (40) is just as thick as the first metal layer (36), and that the third metal layer (20) is thinner than the first metal layer and also thinner than the second metal layer (40), whereby the first metal layer (36) forms an underside (16) of the stack of layers and the underside (16) of the stack of layers is connected to a cooling unit.

2. Assembly according to claim 1, **characterized in that** a through-contact ending in the third metal layer (20) is positioned such that its end in the third metal layer (20) is in an imprint (22) of a component to be installed there.

3. Assembly according to one of the preceding claims, **characterized in that** the third metal layer (20) is designed to make electric and thermal contact with structural elements (10) installed on it, in particular light-emitting diodes.

4. Assembly according to one of the preceding claims, **characterized in that** the thickness of the first metal layer (36) is 84 to 254 µm.

5. Assembly according to one of the preceding claims, **characterized in that** the first metal layer (36) is made from copper or an alloy containing copper.

6. Assembly according to one of the preceding claims, **characterized in that** the first dielectric layer (38) is an FR4 layer made from a fiber-reinforced, hardening resin, or a CE-3 layer.

7. Assembly according to one of the preceding claims, **characterized in that** the second metal layer (40) on top of the first dielectric layer (38) is 84 to 254 µm thick.

8. Assembly according to one of the preceding claims, **characterized in that** the second metal layer (40) is made from the same metal as the first metal layer (36).

9. Assembly according to one of the preceding claims, **characterized in that** the second dielectric layer (42) is an FR4 layer made from a fiber-reinforced, hardening resin, or a CEM-3 layer.

10. Assembly according to one of the preceding claims, **characterized in that** the metallization of the bores is made from the same metal as the metal layers to be connected, preferably copper or an alloy containing copper.

11. Assembly according to claim 10, **characterized in that** the layer thickness of the metallization of the bores is less than the radius of the bore, so that sleeve-shaped metal through-contacts are created.

## Revendications

1. Agencement comprenant une carte de circuit imprimé (12) destinée à des dispositifs d'éclairage de véhicule automobile, qui présente un empilement de couches constitué d'une première couche métallique (36), d'une première couche diélectrique (38) adhérant à ladite première couche métallique, d'une deuxième couche métallique (40) adhérant à ladite première couche diélectrique, d'une deuxième couche diélectrique (42) adhérant à ladite deuxième couche métallique et d'une troisième couche métallique (20) adhérant à ladite deuxième couche diélectrique, la troisième couche métallique étant conçue pour établir un contact électrique avec des diodes électroluminescentes agencées sur celle-ci et pour absorber la chaleur produite dans les diodes électroluminescentes, et la carte de circuit imprimé (12) présentant des contacts traversants métalliques (A, B, C, E) qui relient thermiquement la troisième couche métallique (20) à la deuxième couche métallique (40) et des contacts traversants métalliques (A, D, E) qui relient thermiquement la deuxième couche métallique (40) à la première couche métallique (36), la première couche diélectrique (38) étant un composant d'une couche revêtue de cuivre et constituée de résine renforcée par des fibres, la deuxième couche diélectrique (42) étant une couche de résine d'une épaisseur d'au plus 100 micromètres renforcée par des fibres, les contacts traversants métalliques étant des alésages pourvus d'une métallisation, la première couche diélectrique (38) étant plus épaisse que la deuxième couche diélectrique, et la deuxième couche métallique (40) présentant exactement la même épaisseur que la première couche métallique (36), et la troisième couche métallique (20) étant plus mince que la première couche métallique et également plus mince que la deuxième couche métallique (40), la première couche métallique (36) formant une face inférieure (16) de l'empilement de couches et la face inférieure (16) de l'empilement de couches étant reliée à un dissipateur thermique.

2. Agencement selon la revendication 1, **caractérisé en ce qu'**un contact traversant métallique se terminant dans la troisième couche métallique (20) est agencé de sorte que son extrémité située dans la troisième couche métallique (20) est située dans une empreinte (22) d'un composant qui y est à installer.

3. Agencement selon l'une quelconque des revendications précédentes, **caractérisé en ce que** la troisième couche métallique (20) est conçue pour établir un contact électrique et thermique avec des composants (10), en particulier des diodes électroluminescentes, agencés sur elle.

4. Agencement selon l'une quelconque des revendications précédentes, **caractérisé en ce que** l'épaisseur de la première couche métallique (36) est comprise entre 84 à 254 µm.

5. Agencement selon l'une quelconque des revendications précédentes, **caractérisé en ce que** la première couche métallique (36) est constituée de cuivre ou d'un alliage comprenant du cuivre.

6. Agencement selon l'une quelconque des revendications précédentes, **caractérisé en ce que** la première couche diélectrique (38) est une couche en FR4 constituée d'une résine durcissante renforcée par des fibres ou une couche en CEM-3.

7. Agencement selon l'une quelconque des revendications précédentes, **caractérisé en ce que** la deuxième couche métallique (40) reposant sur la première couche diélectrique (38) présente une épaisseur comprise entre 84 à 254 µm.

8. Agencement selon l'une quelconque des revendications précédentes, **caractérisé en ce que** la deuxième couche métallique (40) est constituée du même métal que la première couche métallique (36).

9. Agencement selon l'une quelconque des revendications précédentes, **caractérisé en ce que** la deuxième couche diélectrique (42) est une couche en FR4 constituée d'une résine durcissante renforcée par des fibres ou une couche en CEM-3.

10. Agencement selon l'une quelconque des revendications précédentes, **caractérisé en ce que** la métallisation des alésages est constituée du métal dont sont constituées également les couches métalliques à relier, c'est-à-dire de manière particulièrement préférée de cuivre ou d'un alliage comprenant du cuivre.

11. Agencement selon la revendication 10, **caractérisé en ce que** l'épaisseur de couche de la métallisation des alésages est inférieure au rayon de l'alésage, de sorte qu'il en résulte des contacts traversants métalliques en forme de manchon.
